# EUROPEAN PATENT SPECIFICATION

(11) **EP 0 284 433 B1**
(45) Date of publication and mention of the grant of the patent: **02.12.1998**
(21) Application number: 88302717.9
(22) Date of filing: 25.03.1988
(51) Int. Cl.: H01L 21/20, C30B 25/18, H01L 21/36, C30B 19/12, C30B 25/02

(54) **Crystal articles and method for forming the same**
Kristalline Gegenstände und Verfahren zu ihrer Herstellung
Articles cristallins et leur procédé de fabrication

(30) Priority: 27.03.1987 JP 73516/87
(43) Date of publication of application: 28.09.1988
(73) Proprietor: CANON KABUSHIKI KAISHA, Tokyo (JP)
(72) Inventor: Osada, Yoshiyuki, Atsugi-shi Kanagawa-ken (JP)
(74) Representative: Beresford, Keith Denis Lewis

(56) References cited:
- EP-A- 180 751
- EP-A- 244 081
- US-A- 3 620 833
- THIN SOLID FILMS, vol. 115, no. 3, May 1984, pages 237-243, Elsevier Sequoia, Lausanne, CH; A.G. ABDULLAYEV et al.: "The simultaneous growth of monocrystalline and polycrystalline silicon films with controlled parameters"
- APPLIED PHYSICS LETTERS, vol. 48, no. 2, January 1986, pages 142-144, American
- Institute of Physics, New York, US; J.M. HONG et al.: "Selective-area epitaxy of GaAs through silicon dioxide windows by molecular beam epitaxy"
- JOURNAL OF THE ELECTROCHEMICAL SOCIETY, vol. 129, no. 10, October 1982, pages 2303-2306, Manchester, New Hampshire, US; D.D. RATHMAN et al.: "Lateral epitaxial overgrowth of silicon on SiO2"
- BRITISH JOURNAL OF APPLIED PHYSICS, vol. 18, no. 10, October 1967, pages 1357- 1382, GB; J.D. FILBY et al.: "Single-crystal films of silicon on insulators"

## Description

The present invention relates to a method of deposition for producing one or more single crystals of silicon and one or more polycrystals of silicon on the surface of a substrate.

Monocrystalline thin films used in semiconductor devices or optical devices have hitherto been formed by epitaxial growth on a monocrystalline substrate. For example, on a Si monocrystalline substrate (e.g. a silicon wafer), Si is known to be epitaxially grown from a liquid phase, gaseous phase or solid phase. Using semiconductor thin films thus formed, semiconductor devices, integrated circuits, light-emitting devices such as semiconductor lasers and LED's etc. are fabricated.

Recently, research and development is also made extensively on very high-speed transistors employing two-dimensional electron gas, super lattice devices utilising a quantum well, but it is the high precision epitaxial technique as exemplified by MBE (molecular-beam epitaxy) using ultra-high vacuum, MOCVD (metal organic chemical vapour deposition), etc. that has made these possible.

In the epitaxial growth effected on such a monocrystalline substrate, it is required to match the lattice constant and thermal expansion coefficient between the monocrystalline material of the substrate and the epitaxial growth layer. An insufficiency in this matching may result in the growth of lattice defects in the epitaxial layer. It may also occur that elements constituting the substrate are diffused into the epitaxial layer.

Thus, the conventional method of forming a monocrystalline thin film by epitaxial growth is seen to greatly depend on the materials of the substrate. Mathews et al have examined the combination of the substrate material with the epitaxial growth layer (see EPITAXIAL GROWTH, Academic Press, New York, 1975, ed. by J.W. Mathews).

Also, size of the substrate is 15 cm (6 inches) or so at present in the case of Si wafers. In addition, monocrystalline substrates involve high production cost, making high the cost per chip.

Thus, the formation of monocrystalline layers capable of fabricating devices of good quality according to conventional methods has involved a problem that the choice of substrate is limited to a very narrow range.

On the other hand, research and development has been made extensively in recent years on three-dimensional integrated circuits formed by laminating semiconductor devices in the normal direction of a substrate to achieve a highly integrated and multifunctional state. Research and development is also extensively being made year by year on large area semiconductor apparatus in which devices are set in array on an inexpensive glass sheet, such as solar batteries and switching transistors for liquid crystal picture elements.

What is common to each of these is that techniques are needed by which a device quality semiconductor thin film can be formed on an amorphous insulating material and electronic devices such as transistors can be formed thereon. Particularly sought after among these is a technique by which monocrystalline semiconductors of high quality can be formed on an amorphous insulating material.

In general, the build-up of a thin film on an amorphous insulating material such as SiO₂ may make amorphous or polycrystalline the crystalline structure of the built-up film for lack of long-distance order of the substrate material. Here, "amorphous film" refers to a film kept in a state that the short-distance order as in most vicinal atoms is retained but there is no long-distance order more than that, and "polycrystalline film" refers to a film in which monocrystal grains having no particular crystal direction are separated by grain boundaries.

For example, when Si is formed on SiO₂ by a CVD process, amorphous silicon is formed when the deposition temperature is about 600°C or less, and, when the temperature is more than that, polycrystalline silicon is formed having a grain size distributed in the range of from several tens to several hundred nm (several hundred to several thousand Å). The grain size and its distribution may greatly vary depending on the formation conditions.

Polycrystalline thin films having a large grain size of the order of µm (microns) or millimetres have been obtained by fusing and solidifying amorphous or polycrystalline films using an energy beam a laser, or a rod-like heater (see Single Crystal Silicon on Non-single-crystal Insulators, Journal of Crystal Growth, Vol. 63, No. 3, October, 1983, edited by G.W. Cullen).

Measurement of electron mobility based on the properties obtained when transistors are formed on the thus formed thin films of each crystalline structure have revealed that there is attained a mobility of not more than 0.1 cm²/V.sec in the case of amorphous silicon; a mobility of from 1 to 10 cm²/V.sec in the case of polycrystalline silicon having a grain size of several tens nm (several hundred Å); and, in the case of polycrystalline silicon having a large grain size attained by fusion and solidification, a mobility of the same degree as in the case of monocrystalline silicon.

It is seen from these results that there is a great difference in electrical properties between a device formed on a monocrystal area in crystal grains and a device formed across grain boundaries. In other words, built-up films on amorphous substrates, obtained by conventional methods, have an amorphous structure or a polycrystalline structure with a grain size distribution, following that the devices formed thereon have greatly poorer performances as compared with devices formed on monocrystalline layers. For this reason, uses are limited to simple switching devices, solar cells, photoelectric transducers, etc.

Also, in the method of forming polycrystalline thin films having a large grain size by fusion and solidification, the amorphous or monocrystalline thin film is scanned with energy beams for each wafer. Accordingly, there has been a problem that the method requires much time to make the grain size large, it is poor in mass-productivity, and it is not suited for large area application.

As stated in the above, conventional crystal growth methods and crystals thereby cannot readily achieve three-dimensional integration and large area and there is difficulty in practical application to devices, so that it has been impossible to form with ease and at a low cost crystals such as monocrystals and polycrystals which are necessary for the fabrication of devices having good properties and multi-functionality.

The simultaneous growth of monocrystalline and polycrystalline silicon films has been considered hitherto and is described in Thin Solid Films, vol. 115, No. 3, 1984, pages 237-243. In the process described silicon substrates of p-type conductivity, orientation (111) and resistivity 10 γ cm were oxidised to obtain a thermal oxide layer 0.5 µm thick onto which an undoped silicon film nucleation layer 10 nm thick was deposited by low temperature (800-860°C) monosilane pyrolysis. This film was then patterned by photolithography and etching. N-type conductivity Si film was then produced by a high temperature (1220°C) chloride process. This method achieved monocrystalline films alternating with polycrystalline Si films in predetermined areas of the substrate.

The present invention, defined by the appended claims, is intended to provide a method of forming one or more silicon monocrystals and one or more silicon polycrystals avoiding the above problems and which, if desired, can readily achieve three-dimensional integration and be applied to large areas. The monocrystalline and polycrystalline silicon produced can have excellent properties.

The present method of deposition utilises the selective nucleation and epitaxial growth of silicon on a silicon oxide surface selectively implanted in specific areas with Si ions. It is mentioned that a method of deposition which also utilises such selective nucleation and epitaxial growth is described in European Patent Application EP-A-0244081.

A method of selective nucleation and epitaxial growth of silicon on silicon dioxide is also described in United States Patent US-A-3,620,833. In the method described therein, nucleation sites are defined by imprinting a nucleation agent using a tipped tool. Examples of nucleation agent include various organic compounds, inorganic salts, bases and acids, a particular example being a diluted photosensitive resist composition such as KMER (Kodak Metal Etch Resist). Alternatively, damaged sites are produced using a tipped tool or using a beam of concentrated energy, such as an electron beam.

In the accompanying drawings:
Figs. 1(A) and 1(B) are cross-sections illustrating a process of crystal growth, of which Fig. 1(A) illustrates a state of a substrate right before crystal growth, and Fig. 1(B) illustrates a state of crystals under growth;
Figs. 2(A) and 2(B) are views illustrating a state of grown crystals, of which Fig. 2(A) is a cross-section and Fig. 2(B) is a top plan view;
Fig. 3 is a graph showing the relationship between the dose of Si-ion implantation into a SiO₂ surface and Si nucleation density;
Figs. 4(A) to 4(C) are views illustrative of an example to show the relationship between a nucleation surface and grown crystals, of which Fig. 4(A) is a cross-section, Fig. 4(B) is a cross-section after flattening treatment, and Fig. 4(B) is a top plan view; and
Figs. 5(A) to 5(C) are views illustrative of a device, of which Fig. 5(A) is a cross-section of the device, Fig. 5(B) is an equivalent circuit of the device, and Fig. 5(C) is a timing chart.

The present invention utilises the fact that the nucleation density (ND) of silicon differs depending on the material of the surface on which it is grown. For example, when an Si crystal is built up, SiO₂ has a small nucleation density (ND_{S}), and Si ion-implanted SiO₂ has a larger nucleation density (ND_{L}). And, on a substrate having an SiO₂ surface and an Si ion implanted SiO₂ surface, the Si crystal is built up to grow only on Si ion-implanted SiO₂ and does not grow on SiO₂, because of the difference (ΔND) in this nucleation density. The surface having the large nucleation density (ND_{L}) and on which crystals are built up to grow like this is called a nucleation surface (S_{NDL}), and the surface having a small nucleation density (ND_{S}) and on which no crystal grows, a nonnucleation surface (S_{NDS}). Here, if the area of the nucleation surface (S_{NDL}) is kept sufficiently small to the extent that only a single nucleus can be produced, this single nucleus grows extending over the nucleation surface (S_{NDL}), also on the nonnucleation surface (S_{NDS}).

The present invention makes use of a technique for such selective formation of Si crystals, thereby making it possible to obtain Si crystals comprised of monocrystals and polycrystals formed on the same substrate in a controlled manner.

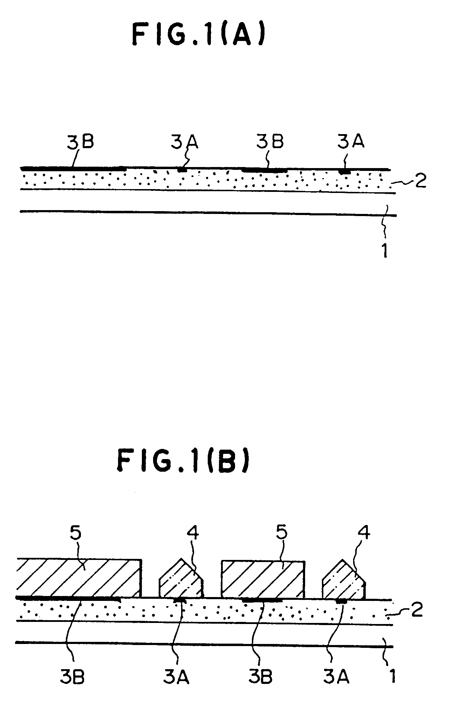

Details of the present invention will be described below with reference to the drawings. In Fig. 1(A), illustrated is a substrate to effect thereon the growth of monocrystals and polycrystals according to the present invention, where used as a base substrate 1 is an insulating substrate made of quartz, heat-resistant glass, alumina, or spinel, a semiconductor substrate made of Si, Ge, GaAs, or InP, or a substrate made of metals such as Mo, Cr, Ti, W, Ta, Al and Fe or an alloy of any of these.

The nonnucleation surface (S_{NDS}) 2 is formed of a material having a small nucleation density, namely a silicon dioxide (SiO₂) film. The SiO₂ film is formed by techniques such as a heat CVD process, a plasma CVD process, an optical CVD process or a sputtering process. In these techniques, a silicon oxide (other than silicon dioxide) SiOₓ (x ≠ 2) film may happen to be formed depending on conditions, but, even in such instance, it can be used as the nonnucleation surface (S_{NDS}) 2.

In instances where the base substrate 1 comprises a crystal silicon substrate, it is possible to oxidise the surface of the silicon substrate by a thermal oxidation process to obtain the SiO₂ film.

The nucleation surface (S_{NDL}) 3 is constituted of Si ion implanted SiO₂ or SiOₓ having a sufficiently larger nucleation density than the above SiO₂ or SiOₓ nonnucleation surface (S_{NDS}) 2.

As the method of forming the nucleation surface (S_{NDL}) 3 by Si ion implantation, a concentrated Si ion beam is scanned across the nonnucleation surface (S_{NDS}) 2 according to a focusing ion beam (FIB) technique without use of any resist mask, to obtain the nucleation surface (S_{NDL}) 3 with a desired pattern and desired arrangement.

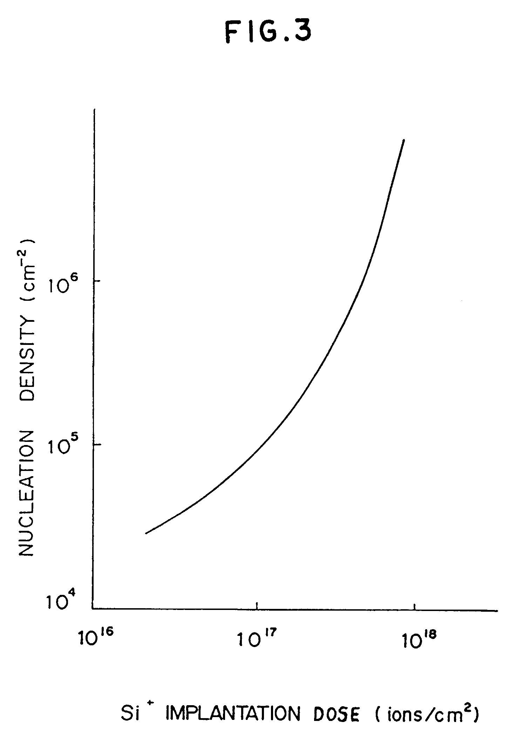

A feature in the method employing the above ion implantation process is that it is possible to control the nucleation density by only controlling the dose of ion implantation. Fig. 3 is a graph showing the relationship between the dose of ion implantation and Si-nucleation density when Si ions are implanted on a thermally oxidised SiO₂ film. As shown in the graph, the nucleation density of Si crystals is seen to unequivocally change depending on the Si-ion implantation dose.

A single nucleation surface (S_{NDL}-S) 3A and a multiple nucleation surface (S_{NDL}-M) 3B will be described below.

The single nucleation surface 3A and the multiple nucleation surface 3B is constituted of materials of different quality and composition. Accordingly, it is possible that the area of the multiple nucleation surface (S_{NDL}-M) 3B is smaller than the area of the single nucleation surface (S_{NDL}-S) 3A since the quality and composition of the multiple nucleation surface (S_{NDL}-M) 3B is different from the quality and composition of the single nucleation surface (S_{NDL}-S) 3A and the nucleation density of the multiple nucleation surface (S_{NDL}-M) 3B is larger than the nucleation density of the single nucleation surface (S_{NDL}-S) 3A. Thus, in the present invention, no direct designation is made in relation to the areal relationship between the single nucleation surface (S_{NDL}-S) 3A and the multiple nucleation surface (S_{NDL}-M) 3B, and the respective areas are defined from the viewpoint that only one monocrystal grown from only a single nucleus is formed on the single nucleation surface (S_{NDL}-S) 3A and a plurality of crystals grown from plural nuclei are obtained on the multiple nucleation surface (S_{NDL}-M) 3B. Thus, the fact that the areas of the single nucleation surface (S_{NDL}-S) 3A and multiple nucleation surface (S_{NDL}-M) 3B are not in any direct relationship to mutually have the degree of freedom is also important from the viewpoint of assuring the degree of freedom in designing a device employing the monocrystal and polycrystal formed on the respective surfaces.

Crystal growth effected on the substrate formed with the constitution and by the process as described above will be described below. A chemical vapour deposition process is used. This may be a thermal CVD process, a plasma CVD process, an optical CVD process, or an MOCVD process. Herein, however, the description will be restricted to a thermal CVD process as example.

First, the substrate shown in Fig. 1(A) is set in a thermal CVD apparatus, and the substrate temperature is raised to a given degree, followed by flowing a carrier gas and then a silicon source gas mixed in the carrier gas to cause Si crystals to grow. In the thermal CVD process, generally used is a substrate temperature of from 600°C to 1,200°, particularly desirably from 800°C to 1,100°C. Used as the carrier gas is H₂ gas and used as the silicon source gas are SiH₄, SiH₂Cl₂, SiHCl₃, SiCl₄, SiF₄, etc. HCl gas may also be optionally used as an additional gas.

Applying the Si crystal treatment as described above, Si crystals grow only from the nucleation surfaces (S_{NDL}) 3A and 3B as shown in Fig. 1(B) and do not grow from the SiO₂ film. Only the monocrystal is formed from the single nucleation surface (S_{NDL}-S) 3A and a monocrystal 4 grows from this single nucleus until it covers the SiO₂ film.

On the other hand, in the course of the above crystal growth treatment, plural nuclei are formed on the multiple nucleation surface (S_{NDL}-M) 3B and an Si polycrystal grows thereon, where the growth further proceeds until they cover the SiO₂ film. At this time, the grain size of the Si polycrystal in the multiple nucleation surface (S_{NDL}-M) 3B at least depends on the nucleation density of the multiple nucleation surface (S_{NDL}-M) 3B, where the larger the nucleation density is, the smaller the grain size becomes, or the smaller the nucleation density is, the grain size becomes larger. The size of a multiple-nucleation surface is desired to be large enough to allow as much nucleation as possible, and is preferably 20 µm or larger, more preferably 30 µm or larger.

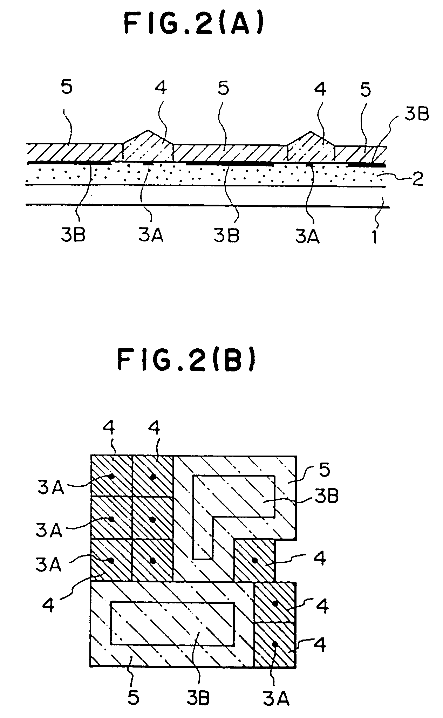

Fig. 2(A) is a view illustrating a cross-section of grown crystals, and Fig. 2(B), a top plan view thereof. As shown in Fig. 2(A) and Fig. 2(B), the technique presented by the present invention can achieve simultaneously the formation of Si monocrystals 4 and polycrystals 5 on any desired base substrate 1. The respective monocrystals and polycrystals can be formed in a controlled manner at any desired positions and in any desired shapes. The monocrystals and polycrystals thus formed are of sameness in the material and also can cover the whole surface of the substrate. Accordingly, the surface can be readily flattened. It is also readily possible to separate the respective monocrystals by the etching of grain boundaries of the respective monocrystals and to re-work the polycrystal areas into any desired shapes according to a photolithographic process.

The grain boundaries of the above respective monocrystals can be formed at substantially the central position of a plurality of single nucleation surfaces (S_{NDL}-S) 3A, thus making it possible to carry out the separation of the monocrystals at the grain boundary areas by the above etching, by using a photomask designed and prepared in advance.

### Example

On a fused quartz substrate the plasma CVD process was applied using SiH₄ gas and oxygen gas, diluted with hydrogen gas, to form an SiOₓ film with a film thickness of about 100 nm (1,000 Å). Next, Si-ion implantation was effected only on desired positions on the above SiOₓ film with use of a focusing ion beam apparatus. The implantation was carried out under the conditions of an accelerated voltage of 50 keV, a beam diameter of 0.4 µm, and an implantation dose of 2 x 10¹⁸ cm⁻² at the areas corresponding to the single nucleation surfaces (S_{NDL}-S) 3A-5 to 3A-8, and 3 x 10¹⁹cm⁻² at the areas corresponding to the multiple nucleation surfaces (S_{NDL}-M) 3B-5 to 3B-8. The single nucleation surfaces (S_{NDL}-S) 3A-5 to 3A-8 were made to have shapes of squares with a side of 2.0 µm each, and the multiple nucleation surface (S_{NDL}-M), shapes of rectangles of 20 µm long and 30 µm broad each. These single nucleation surfaces were each longwise arranged in a line with a distance of 25 µm between centres, and on the side area thereof the multiple nucleation surfaces were similarly longwise arranged in a line with a distance of 25 µm between centres. Here, the distance between the centre of a single nucleation surface and the centre of a multiple nucleation surface were made to be 28 µm.

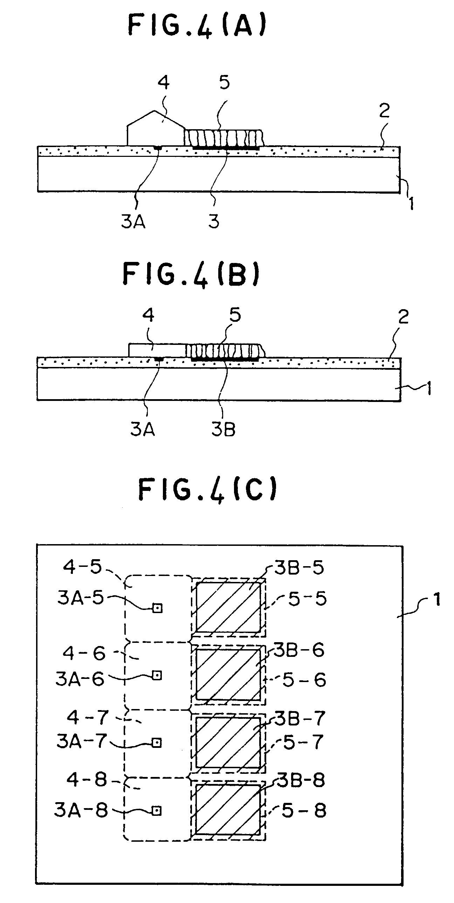

This substrate was set in an epitaxial growth apparatus to allow Si crystals to grow under the conditions of a substrate temperature of 1,030°C., a gas flow rate of SiH₂Cl₂/HCl/H₂ = 1.7 lit/min/1.3 lit/min/100 lit/min, and a total pressure of 2.33 x 10⁴ Pa (175 Torr). As a result, there were obtained monocrystals 4-5 to 4-8 and polycrystals 5-5 to 5-8 as shown in the cross-section of Fig. 4(A) and the plan view of Fig. 4(C). The monocrystals 4 had a grain size of about 25 µm, and the polycrystals 5, an average grain size of about 0.5.

The resulting crystals were flattened on these surfaces by mechanical grinding and chemical grinding to obtain a flat crystal thin film with average thickness of about 3 µm for both the monocrystals 4 and polycrystals 5.

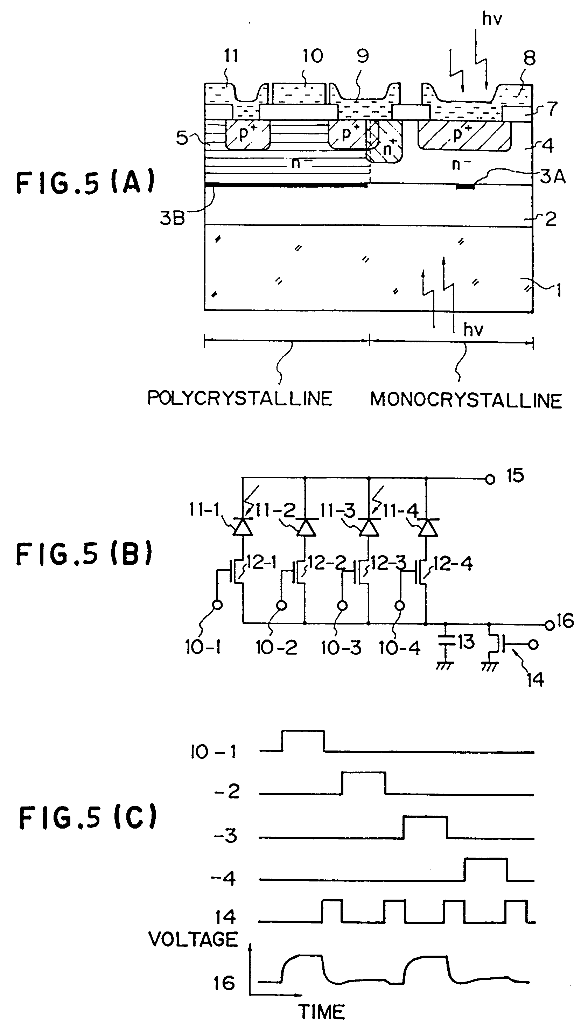

On the flattened crystalline thin film (Fig.4(B)) prepared in the above Example, a circuit as shown in Fig. 5(B) was prepared. Photodiodes were prepared on the monocrystalline areas 4, and switching MOS transistors, on the polycrystalline areas 5. A cross-section of the device at this time is shown in Fig. 5(A). In Fig. 5(A), the numeral 7 denotes the SiO₂ film formed by the CVD process; 8 to 11, electrodes comprising transparent conductive films, wherein, 8, an electrode of the photodiode; 9, a source electrode of the MOS transistor; 10, a gate electrode; and 11, a drain electrode.

The photodiodes were made to have shapes of squares with about 10 µm square each at the junction portion, and the MOS transistors, to have a channel length of 4 µm and a channel width of 6 µm for each. At this time, the MOS transistors had a field-effect mobility of about 3.0 cm²/V•s and a threshold voltage of about 3.5 V. To terminals 10-1 to 10-4 and 14 as shown in Fig. 5(B), pulses as shown in the timing chart of Fig. 5(C) were applied, and at the same time a He-Ne laser beam was concentrated to a diameter of about 10 µm and irradiated targeting the photodiodes 11-1 and 11-2 from the surface or reverse side of the quartz substrate to obtain in an output terminal 16 the output wave form as shown in Fig. 5(C). At this time, another He-Ne laser beam was irradiated to MOS transistors 12-1 to 12-4 with similar intensity to have observed little change in the output wave form in the output terminal 6.

This is because the life time of photocarriers in the polycrystalline Si was short, and the employment of the crystal growth method according to the present invention made it possible to simultaneously internally make up the monocrystalline Si having a high sensitivity to light and the polycrystalline Si having a low sensitivity to light on the same substrate. This shows the capability that even mutually disagreeable functions can be readily formed in the same substrate and with use of the same kind of materials, thus suggesting the possibility that multi-functional devices can be readily prepared by using the crystal growth method described.

## Claims

1. A method of deposition for producing on the surface (2,3A,3B) of a substrate (1) one or more single crystals (4) of silicon and one or more polycrystals (5) of silicon, which method comprises the following steps:
providing a substrate (1) having a non-nucleation surface (2) of silicon oxide;
scanning said non-nucleation surface (2) of said substrate (1) with a focused beam of silicon ions to implant silicon ions into selected areas (3A,3B), which selected areas (3A,3B), namely one or more first nucleation surface areas (3A) and one and more second nucleation surface areas (3B), nucleate silicon at a higher nucleation density than said non-nucleation surface (2), and differ by the respective number per unit area of silicon ions implanted therein, said first nucleation areas (3A) each being of a small enough size for growing silicon from a single silicon nucleus,said second nucleation areas (3B) each being of a large enough size for growing silicon from a plurality of silicon nuclei;
subjecting said substrate wich said first and second deposition areas to chemical vapour deposition of silicon and thereby
i) forming a single silicon nucleus on each of said one or more first nucleation surface areas (3A) and a plurality of silicon nuclei on each of said one or more second nucleation surface areas (3B); and then
ii) growing a single crystal of silicon (4) from each single silicon nucleus and a polycrystal of silicon (5) from said plurality of silicon nuclei until the non-nucleation surface (2), surrounding said first and second nucleation surface areas (3A,3B), is covered by silicon (4,5) grown from said single and plural silicon nuclei.

2. A method as claimed in claim 1 wherein:
said step of providing a substrate (1) having a non-nucleation surface (2) of silicon oxide is performed by thermal oxidation of a crystal silicon substrate (1) to produce a SiO₂ film (2).

3. A method as claimed in claim 1 wherein:
said step of providing a substrate (1) having a non-nucleation surface (2) of silicon oxide is performed by producing a silicon oxide film (2) of 100 nm (1000Å) thickness on a fused quartz substrate using a CVD plasma of silane gas and oxygen gas with hydrogen gas dilution;
said step of scanning to implant silicon ions is performed at an acceleration voltage of 50 keV and ion beam diameter 0.4 µm, and 2x10¹⁸ cm⁻² and 3x10¹⁹ cm⁻² silicon ions respectively are implanted to produce said first and second nucleation surface areas (3A,3B), 2.0 µm square and 20 µm x 30 µm respectively, said first nucleation surface areas (3A) being arranged in line and said second nucleation surface areas (3B) being arranged in line each at 25 µm centre-to-centre spacing and said first and second nucleation surface areas (3A,3B) having a centre-to-centre spacing of 28 µm therebetween; and
said steps of subjecting said substrate with said first and second deposition areas to chemical vapour deposition of silicon is performed at a substrate temperature of 1,030°C at a gas flow rate of SiH₂ Cℓ₂ : HCℓ : H₂ of 1.7 : 1.3 : 100 ℓ/min and total pressure of 2.33x10⁴Pa (175 Torr).

4. A method as claimed in claim 3 wherein:
said single crystals of silicon (4) and polycrystals of silicon (5) are ground mechanically and chemically to a film thickness of 3µm.

5. A method as claimed in claim 4 wherein photodiodes (11-1 to 11-4) and switching MOS transistors (12-1 to 12-4) are prepared on the ground areas of single crystals of silicon (4) and polycrystals of silicon (5), respectively.

## Patentansprüche

1. Abscheidungsverfahren zur Produktion von einem oder mehreren Si-Einkristallen (4) und einem oder mehreren Si-Polykristallen (5) auf der Oberfläche (2, 3A, 3B) eines Substrats (1) mit den folgenden Schritten:
Vorbereiten eines Substrats (1) mit einer nicht keimbildenden Siliziumoxidoberfläche (2),
Abtasten der nicht keimbildenden Oberfläche (2) des Substrats (1) mit einem fokussierten Siliziumionenstrahl zur Implantierung der Siliziumionen in ausgewählte Bereiche (3A, 3B), wobei sich Silizium in diesen ausgewählten Bereiche, namentlich eine oder mehrere Erstkeimbildungsoberflächenbereiche (3A) und eine oder mehrere Zweitkeimbildungsoberflächenbereiche (3B), mit einer höheren Keimbildungsdichte anlagert, als an der nicht keimbildenden Oberfläche (2) und die sich in der Anzahl der implantierten Siliziumionen pro Flächeneinheit unterscheiden, wobei die Erstkeimbildungsbereiche (3A) alle klein genug zum Aufwachen von Silizium aus einem einzelnen Siliziumkeimling sind und die Zweitkeimbildungsbereiche (3B) alle groß genug zum Aufwachsen von Silizium aus einer Mehrzahl von Siliziumkeimlingen sind,
Aussetzen des Subtstrats mit den Erst- und Zweitabscheidungsbereichen der chemischen Gasphasenabscheidung von Silizium und dabei
i) Bilden eines einzelnen Siliziumkeimlings auf dem einen bzw. jedem der mehreren Erstkeimbildungsoberflächenbereiche (3A) und einer Mehrzahl von Siliziumkeimlingen auf dem einen bzw. jedem der mehreren Zweitkeimbildungsoberflächenbereiche (3B), und
ii) Aufwachsen eines Siliziumeinkristalls (4) aus jedem einzelnen Siliziumkeimling und eines polykristallinen Siliziums (5) aus der Mehrzahl von Siliziumkeimlingen bis die nicht keimende Oberfläche (2), welche die Erst- und Zweitkeimbildungsoberflächenbereiche (3A, 3B) umgibt, von dem aus dem einzelnen und den mehreren Siliziumkeimlingen gewachsenen Silizium (4,5) bedeckt ist.

2. Verfahren nach Anspruch 1, wobei der Schritt zur Vorbereitung des Substrats (1) mit einer nicht keimbildenden Oberfläche (2) aus Siliziumoxid durchgeführt wird, indem eine SiO₂-Schicht (2) durch thermische Oxidation einer kristallinen Siliziumoberfläche (1) hergestellt wird.

3. Verfahren nach Anspruch 1, wobei
der Schritt zur Vorbereitung des Substrats (1) mit einer nicht keimbildenden Oberfläche (2) aus Siliziumoxid durchgeführt wird, indem mit einem CVD-Plasma aus Silan- und Sauerstoffgas mit Wasserstoffgasverdünnung eine Siliziumoxidschicht (2) von 100 nm (1000 Å) Dicke auf einem aufgeschmolzenen Quartzsubstrat hergestellt wird,
der Schritt des Abtastens zur Implantierung von Siliziumionen bei einer Beschleunigungsspannung von 50 KeV und einem Ionenstrahldurchmesser von 0,4 um durchgeführt wird, und 2^{.}10¹⁸ cm⁻² bzw. 3^{.}10¹⁹ cm⁻² Siliziumionen implantiert werden, um (2,0 µm)² der Erst- bzw. 20·30 µm² der Zweitkeimbildungsbereiche (3A, 3B) herzustellen, wobei die Erstkeimbildungsoberflächenbereiche (3A) in einer Linie angeordnet werden und die Zweitkeimbildungsoberflächenbereiche (3B) in einer Linie angeordnet werden, mit jeweils 25µm Mittenabstand und 28 µm Mittenabstand zwischen den Bereichen der Erstkeimbildungsoberflächen und der Zweitkeimbildungsoberflächen, und
die Schritte, bei denen die ersten und zweiten Abscheidebereiche des Substrats der chemischen Gasphasenabscheidung von Silizium ausgesetzt werden bei einer Substrattemperatur von 1030 °C, einem Gasdurchfluß SiH₂Cl₂ : HCl : H₂ von 1,7 : 1,3 : 100 l/min und einem Gesamtdruck von 2,33.10⁴ Pa (175 Torr) durchgeführt werden.

4. Verfahren nach Anspruch 3, wobei
die Siliziumeinkristalle (4) und Siliziumpolykristalle (5) mechanisch und chemisch auf eine Schichtdicke von 3 µm abgetragen werden.

5. Verfahren nach Anspruch 4, wobei
auf den Grundflächen der Siliziumeinkristalle (4) und den Siliziumpolykristallen (5) Photodioden (11-1 bis 11-4) bzw. MOS-Schalttransistoren (12-1 bis 12-4) hergestellt werden.

## Revendications

1. Procédé de dépôt pour la production sur la surface (2, 3B, 3B) d'un substrat (1) d'un ou plusieurs monocristaux (4) de silicium et d'un ou plusieurs polycristaux (() de silicium, procédé qui comprend les étapes consistant :
à prendre un substrat (1) ayant une surface de non-nucléation (2) constituée d'oxyde de silicium ;
à balayer ladite surface de non-nucléation (2) dudit substrat (1) avec un faisceau focalisé d'ions silicium pour implanter des ions silicium dans des zones choisies (3A, 3B), ces zones choisies (3A, 3B), à savoir une ou plusieurs premières zones de surface de nucléation (3A) et une ou plusieurs secondes zones de surface de nucléation (3B), présentant une nucléation de silicium à une densité de nucléation supérieure à celle de ladite surface de non-nucléation (2), et différant par le nombre respectif par surface unitaire d'ions silicium implantés dans ces zones, lesdites premières zones de nucléation (3A) ayant chacune des dimensions suffisamment petites pour permettre la croissance du silicium à partir d'un seul germe de silicium, lesdites secondes zones de nucléation (3B) ayant chacune des dimensions suffisamment grandes pour permettre la croissance du silicium à partir d'une pluralité de germes de silicium ;
à soumettre ledit substrat avec lesdites première et seconde zones de dépôt à un dépôt chimique en phase vapeur de silicium ; et ainsi
i) à former un germe de silicium unique sur chacune desdites une ou plusieurs zones de surface de nucléation (3A) et une pluralité de germes de silicium sur chacune desdites une ou plusieurs secondes zones de surface de nucléation (3B), puis
ii) à former un monocristal de silicium (4) à partir de chaque germe de silicium unique et un polycristal de silicium (5) à partir de ladite pluralité de germes de silicium jusqu'à ce que la surface de non-nucléation (2), entourant lesdites première et seconde zones de surface de nucléation (3A, 3B), soit couverte par du silicium (4, 5) formé à partir dudit germe de silicium unique et de ladite pluralité de germes de silicium.

2. Procédé suivant la revendication 1, dans lequel :
l'étape consistant à prendre un substrat (1) ayant une surface de non-nucléation (2) d'oxyde de silicium est mise en oeuvre par oxydation thermique d'un substrat en silicium cristallin (1) pour produire un film de SiO₂ (2).

3. Procédé suivant la revendication 1, dans lequel :
l'étape consistant à prendre un substrat (1) ayant une surface de non nucléation (2) d'oxyde de silicium est mise en oeuvre en produisant un film d'oxyde de silicium (2) de 100 nm (1000 Å) d'épaisseur sur un substrat en quartz fondu en utilisant un procédé CVD par plasma constitué d'un silane gazeux et d'oxygène gazeux, avec dilution au moyen d'hydrogène gazeux ;
ladite étape de balayage pour l'implantation d'ions silicium est mise en oeuvre à une tension d'accélération de 50 keV et un diamètre de faisceau ionique de 0,4 µm, et 2x10¹⁸ cm⁻² et 3x10¹⁹ cm⁻² ions silicium, respectivement, sont implantés pour produire lesdites première et seconde zones de surface de nucléation (3A, 3B), ayant, respectivement, les dimensions d'un carré de 2,0 µm de côté et des dimensions de 20 µm x 30 µm, lesdites premières zones de surface de nucléation (3A) étant disposées en ligne et lesdites secondes zones de surface de nucléation (3B) étant disposées en ligne chacune à un espacement d'un centre à l'autre de 25 µm et lesdites première et seconde zones de surface de nucléation (3A, 3B) ayant un espacement d'un centre à l'autre de 28 µm entre ces zones ; et
ladite étape consistant à soumettre le substrat avec lesdites première et seconde zones de dépôt à un dépôt chimique en phase vapeur de silicium est mise en oeuvre à une température du substrat de 1030°C à un débit de gaz SiH₂ Cℓ₂:HCℓ:H₂ de 1,7:1,3:100 ℓ/min et à une pression totale de 2,33x10⁴ Pa (175 torrs).

4. Procédé suivant la revendication 3, dans lequel :
les monocristaux de silicium (4) et les polycristaux de silicium (5) sont meulés mécaniquement et chimiquement à une épaisseur de film de 3 µm.

5. Procédé suivant la revendication 4, dans lequel des photodiodes (11-1 à 11-4) et des transistors à oxyde métallique (MOS) à commutation (12-1 à 12-4) sont préparés sur les zones meulées des monocristaux de silicium (4) et des polycristaux de silicium (5), respectivement.
